# EUROPEAN PATENT APPLICATION

(11) **EP 0 540 235 A2**
(43) Date of publication of application: **05.05.1993**
(21) Application number: 92309614.3
(22) Date of filing: 21.10.1992
(51) Int. Cl.: H01L 31/0352, H01L 27/146

(54) **Article comprising a quantum well infrared photodetector**

(30) Priority: 30.10.1991 US 785354
(71) Applicant: AT&T Corp., New York, NY 10013-2412 (US)
(72) Inventor: Bean, John Condon, New Providence, New Jersey 07974 (US); Bethea, Clyde George, Plainfield, New Jersey 07060 (US); People, Roosevelt, Plainfield, New Jersey 07060 (US); Peticolas, Justin Larry, Wescosville, Pennsylvania 18106 (US); Sputz, Sharon Kay, Teaneck, New Jersey 07666 (US)
(74) Representative: Watts, Christopher Malcolm Kelway, Dr.

(57) **Abstract**

A Si₁₋ₓGeₓ/Si quantum well infrared photodetector capable of detecting normal incidence radiation is disclosed. An array of such detectors is advantageously bump-bonded to a Si read-out circuit chip, or integrated with the read-out circuitry on a Si chip.

## Description

### Field of the Invention

This invention pertains to semiconductor photodetectors. More particularly, it pertains to quantum well photodetectors for relatively long wavelength infrared radiation, including such radiation that is incident in substantially normal direction on the detector.

### Background of the Invention

Arrays of infrared (IR) detectors are useful in many applications, including medical thermography. Advantageously, such arrays (frequently referred to as "staring" arrays) are either monolithically integrated with the required multiplexer read-out circuitry or are bump-bonded to a read-out chip. Since the read-out circuitry typically is implemented in Si technology, and the detector arrays must be cooled (typically to about 50K) during operation, it is highly desirable that the thermal expansion coefficient of the detector material be closely matched to that of Si. GaAs (and other III-V)-based detectors typically do not satisfy this requirement.

Recently a GeₓSi₁₋ₓ/Si detector array was disclosed. See B-Y. Tsaur et al., IEEE Electron Device Letters, Vol. 12(6), p. 293 (1991). The array was monolithically integrated with the read-out circuitry. However, the detectors were single hetero-junction devices that typically have relatively low quantum efficiency (maximum efficiency of about 0.6-1 % at the relatively short wavelength of 3 µm).

Quantum well IR detectors are known and can have relatively high quantum efficiency. See, for instance, US patent 5,023,685, which discloses quantum well detectors designed to utilize a transition from a single bound state to the continuum.

As will be appreciated by those skilled in the art, IR detector arrays typically are most useful if they can detect normally incident radiation. Y-C. Chang et al. (Physical Review B, Vol. 39(17), p. 12672) present theoretical results to the effect that, due to the non-orthogonal nature of the envelope functions in p-type quantum wells, intersubband transitions are allowed for normally incident light.

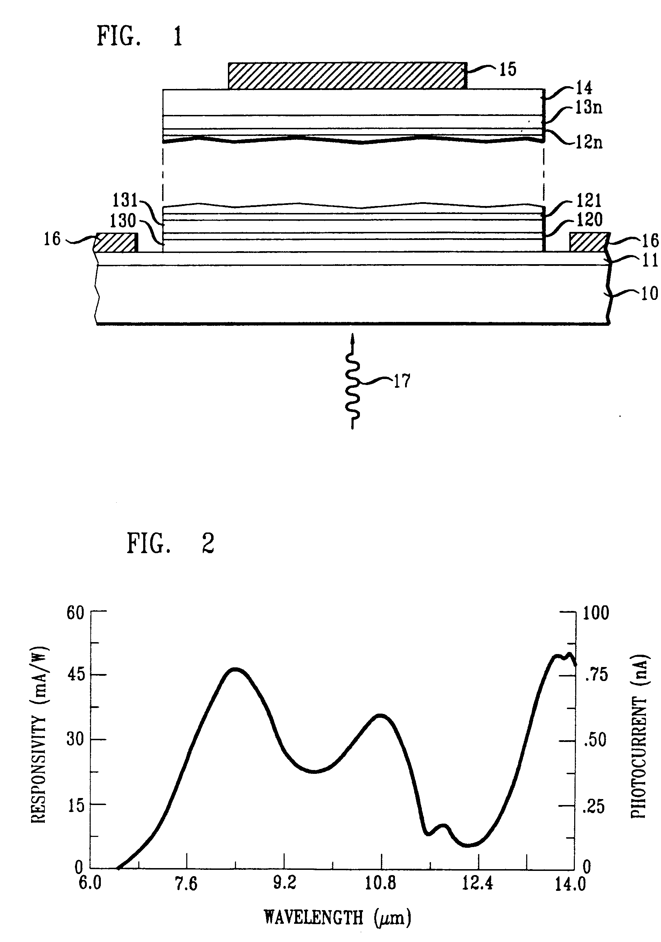

Recent work (R. P. G. Karunasiri et al., Applied Physics Letters, Vol. 57(24), p. 2585 (1990), deals with Si₁₋ₓGeₓ/Si quantum well structures. FIG. 2 of the paper shows that the absorption strength of such a structure approaches zero as the direction of incidence of the IR radiation approaches the normal direction. Such behavior is inconsistent with the theoretical results of Y-C. Chang et al. (op. cit.), and appears incompatible with detection of normal incidence radiation. Thus, the prior art experimental result appears to preclude the possibility of, at least, GeₓSi₁₋ₓx/Si quantum well detectors for normal incidence IR radiation.

### Brief Description of the Drawings

FIG. 1 schematically depicts an exemplary detector according to the invention;
FIG. 2 shows the photo response spectrum of an exemplary device according to the invention;
FIG. 3 schematically shows, in plan view, a portion of an exemplary detector array according to the invention;
FIG. 4 depicts schematically, in side view, a portion of an exemplary inventive combination, namely, a detector array mounted on an appropriate read-out chip; and
FIG. 5 shows an energy level diagram associated with an exemplary device according to the invention.

### The Invention

We have made the surprising discovery that, contrary to expectations based on the above cited prior art experimental results, quantum well structures can advantageously be used to detect normal incidence IR radiation. Such detectors can readily be manufactured in array form, with preferred arrays having essentially the same thermal expansion coefficient as Si-based read-out chips. In a preferred embodiment of the invention a Si₁₋ₓGeₓ/Si quantum well array chip is bump-bonded to a Si-based read-out chip.

The invention is defined by the claims. More particularly, an article according to the invention typically comprises a multilayer structure that comprises a substrate-supported Si₁₋ₓGeₓ/Si superlattice. The superlattice comprises interleaved p-doped strained Si₁₋ₓGeₓ quantum well layers and essentially undoped Si barrier layers. The article further comprises contact means adapted for applying an electrical bias across the superlattice. Significantly, the article is adapted for detection of IR radiation of wavelength(s) of interest that is incident upon the substrate in a direction that is approximately perpendicular to the superlattice. The composition and thickness of the quantum well layers is selected such that the detection of the radiation involves hole intersubband transitions. "Intersubband transitions" is intended to include bound state/bound state transitions as well as bound state/continuum transitions.

An exemplary detector according to the invention was made as follows. On a conventional (100) Si substrate was grown a 200 nm B-doped (∼10¹⁸cm⁻³) Si buffer layer, followed by ten periods of a Ge_{0.25} Si_{0.75}/Si (4 nm, ∼4x10¹⁸ cm⁻³ B/30 nm, undoped) quantum well structure. Onto this was deposited a 100 nm B-doped ( ∼ 10¹⁸ cm⁻³) capping layer. All the layers were deposited by conventional MBE at 550°C. The Ge₁₋ₓSiₓ layer thickness was well below the mechanical equilibrium critical thickness (∼ 10 nm) and the metastable critical thickness (∼100nm) for this composition, thus ensuring pseudomorphic growth. The thus produced multilayer structure was processed by conventional lithography, including reactive ion etching in a CF₄ plasma, to form 200 µm diameter mesas. This was followed by conventional Al metallization for contacting. The resulting detector is schematically depicted in FIG. 1, wherein numerals 10, 11 and 14 refer to the substrate, buffer layer and cap layer, respectively, 120, 121, ..... refer to the quantum well layers, 130, 131, ...... refer to the barrier layers, and 15 and 16 to the contacts. Arrow 17 indicates the incident radiation.

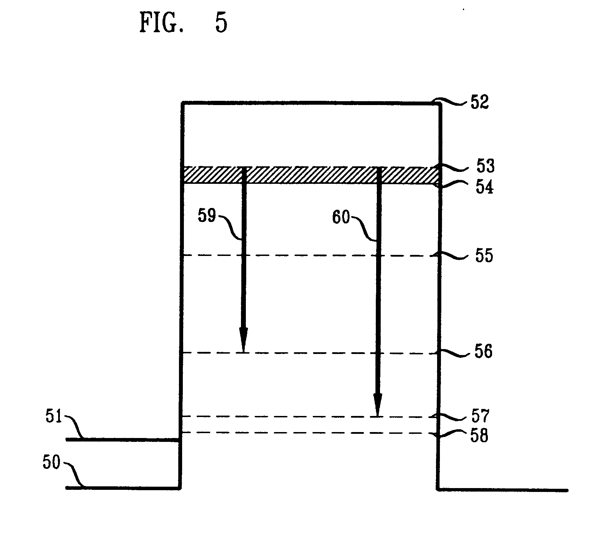

FIG. 2 shows an exemplary 77K normal incidence photo response spectrum for the described multilayer structure. The spectrum indicates that the peak absorption coefficient of the structure is about 1,120 cm⁻¹ at λ∼8µm, and reveals the presence of three distinct absorption peaks (∼8µm, ∼10.8µm, and approximately 14 µm). The measured quantum efficiency is about 7.3%. The two short wavelength absorption peaks are identified with intersubband transitions, as shown in FIG. 5.

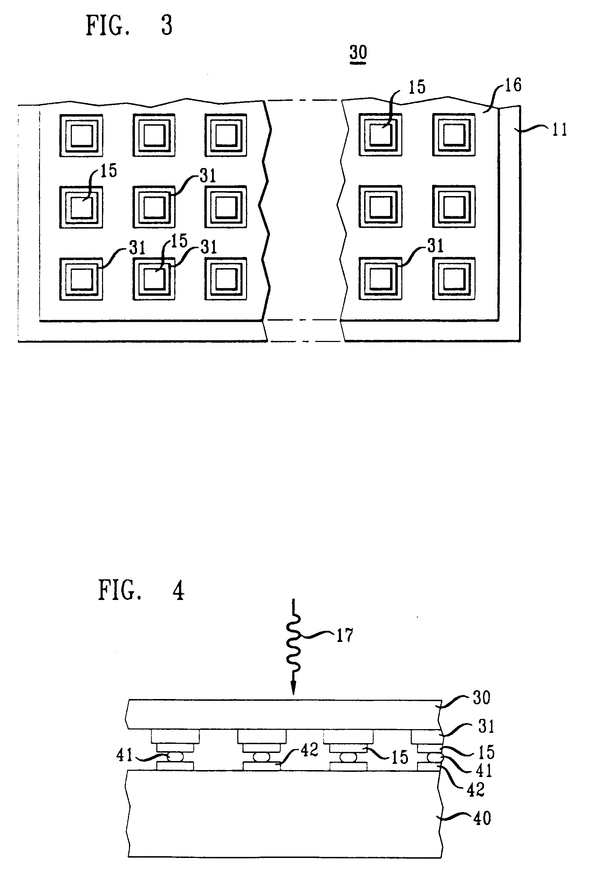

FIG. 3 schematically depicts an exemplary detector array chip 30. It will be appreciated that arrays according to the invention typically will have many thousands of pixels. On Si buffer layer 11 is ground plane metallization layer 16, with a multiplicity of multilayer mesas 31 extending above 16. On the top surface of the mesas are metallization pads 15.

FIG. 4 schematically depicts a portion of an array chip according to the invention (30) mounted on a Si-based chip 40 by means of solder bumps 41 (exemplarily In). Only bonding pads 42 are shown on chip 40, but it will be understood that the chip carries the appropriate circuitry (e.g., multiplexing circuitry) to serve as read-out means for the inventive array. Such circuitry can be conventional and does not require discussion.

It will be appreciated that multilayer structures according to the invention can be made by any appropriate growth technique, e.g., MOCVD. The details of the structure typically will depend, inter alia, on the wavelength to be detected. Typically, the value of x (in Si₁₋ₓGeₓ) will be in the range 0.2-0.3, and the thickness of the quantum wells will be in the range 2.5-5.0 nm. There will typically be more than two quantum wells, with ten being a representative number but not necessarily an upper limit. Significantly, the structure is designed such that the absorption of the radiation of interest is associated with transitions between bound and bound or free energy levels.

An exemplary energy level diagram is schematically shown in FIG. 5, wherein numbers 50 and 51 refer to the Si(J=1/2) and Si (J=3/2) valence band edges, respectively, and 52 refers to the (3/2,±3/2) upper valence band edge of the (strained) quantum well. Exemplarily, the energy difference between 52 and 51 is about 0.21 eV. Numerals 53 and 56 refer to first and second heavy hole levels respectively, 55 and 58 to first and second light hole levels, respectively, 57 to the split-off hole level, and 54 to the Fermi energy level. Arrows 59 and 60 indicate the transitions that are believed to be associated with the absorption of the IR radiation of interest. The terminology of the above description is conventional and does not require elaboration.

## Claims

1. An article comprising a multilayer structure comprising a substrate-supported semiconductor superlattice comprising interleaved p-doped quantum well layers (120, 121,....) and essentially undoped barrier layers (130, 131,....), and further comprising contact means (15, 16) adapted for applying an electrical bias across the superlattice; associated with the quantum wells being a thickness d;
CHARACTERIZED IN THAT
a) the article is adapted for detection of radiation ( 17) of a wavelength of interest that is incident upon the substrate in a direction that is approximately perpendicular to the superlattice; and
b) the superlattice is a strained layer Si₁₋ₓGeₓ/Si superlattice, with x and d selected such that detection of the radiation of interest involves intersubband hole transitions.

2. Article according to claim 1, wherein x is in the range 0.2-0.3, and d is in the range 2.5-5.0 nm.

3. Article (30) according to claim 1, comprising a multiplicity of substantially identical multilayer structures that form an array of radiation detectors.

4. Article according to claim 3, further comprising multiplexer circuitry adapted for sequential read-out of electrical signals that are responsive to infrared radiation of the wavelength of interest that is incident on the array.

5. Article according to claim 4, wherein the multiplexer circuitry is formed on said substrate.

6. Article according to claim 4, wherein the multiplexer circuitry is on a Si body that is bonded to said array of radiation detectors.

7. Article according to claim 1, wherein the intersubband transitions comprise bound state/continuum transitions.
